# FASCICULE DE BREVET EUROPEEN

(11) **EP 1 962 173 B1**
(45) Date de publication et mention de la délivrance du brevet: **23.11.2011**
(21) Numéro de dépôt: 08150841.8
(22) Date de dépôt: 30.01.2008
(51) Int. Cl.: G06F 3/03, G06F 3/033, H05K 1/14, H05K 1/18

(54) **Module optoélectronique muni d'au moins un circuit photorécepteur**
Optoelektronisches Modul, das mit mindestens einem Fotorezeptor-Schaltkreis ausgestattet ist
Optoelectronic module equipped with at least one photoreceptor circuit

(30) Priorité: 22.02.2007 CH 3082007
(43) Date de publication de la demande: 27.08.2008
(73) Titulaire: EM Microelectronic-Marin SA, 2074 Marin (CH)
(72) Inventeur: Quercia, Victorio, 1586, Vallamand (CH); Grandjean, André, 2088, Cressier (CH); Kayal, Abdul-Hamid, 2000, Neuchâtel (CH)
(74) Mandataire: Ravenel, Thierry Gérard Louis

(56) Documents cités:
- EP-A- 1 081 944
- WO-A-2005/088435
- US-A- 5 023 498
- US-A1- 2002 134 750
- US-A1- 2004 095 501
- US-A1- 2006 007 148

## Description

L'invention concerne un module optoélectronique muni d'au moins un circuit photorécepteur susceptible de capter de la lumière provenant d'une source de lumière directement ou par réflexion sur une surface extérieure. Le circuit photorécepteur est monté sur un substrat, et des plages de contact du circuit photorécepteur sont électriquement connectées à des plages correspondantes du substrat. Les plages du substrat sont reliées à des pistes conductrices pour former un circuit imprimé.

L'invention concerne également une souris d'ordinateur comprenant un tel module optoélectronique.

Dans le domaine des souris d'ordinateur à fonctionnement optique, le module optoélectronique peut comprendre au moins un circuit photorécepteur monté sur un substrat et enfermé dans un moulage plastique opaque ou encapsulé. Un passage de lumière est réalisé dans le moulage plastique sous la forme d'un diaphragme au-dessus d'une région photosensible du circuit photorécepteur. Ce passage de lumière permet ainsi au circuit de capter de la lumière généralement réfléchie sur une surface de travail de la souris d'ordinateur. Cette lumière est produite par une source de lumière disposée dans le boîtier de la souris d'ordinateur. Cette source de lumière peut également être un circuit source de lumière monté sur le substrat au-dessous d'une ouverture traversante du moulage plastique du module optoélectronique.

Habituellement, un module optoélectronique de l'état de la technique pour une souris d'ordinateur prend la forme d'un composant standard encapsulé de type DIL, comme décrit par exemple dans les demandes de brevet EP 1 339 012, EP 1 361 537 et US 2006/0007148. Ce composant comprend des pattes régulièrement espacées sortant d'un moulage plastique à l'intérieur duquel est disposé le circuit photorécepteur et éventuellement un circuit source de lumière. Les pattes de connexion du module peuvent être insérées dans des trous métallisés d'une carte mère à circuit imprimé logée à l'intérieur de la souris d'ordinateur. Une ouverture de la carte mère à circuit imprimé est également prévue entre les pattes de connexion du module pour permettre l'émission de lumière du circuit source de lumière et la réception de lumière réfléchie par le circuit photorécepteur.

Ce module optoélectronique peut comprendre ou être monté sur un bloc transparent à lentille optique, qui est de préférence fixé au-dessus d'une large ouverture dans le fond du boîtier de la souris d'ordinateur. Il est donc important d'ajuster la hauteur sur la carte mère du module optoélectronique monté sur le bloc transparent à lentille optique par rapport à la surface de travail ou au fond du boîtier de la souris. Cet ajustement en hauteur du module est effectué par rapport à la carte mère avant la connexion électrique par exemple par soudure des pattes de connexion dudit module dans les trous métallisés de la carte. Dans certains cas, une partie des pattes de connexion dépassant des trous métallisés peut être découpée. Ces opérations s'avèrent être relativement longues, donc coûteuses, et difficiles à mettre en pratique pour le montage du module optoélectronique dans le boîtier de la souris d'ordinateur, ce qui constitue un inconvénient.

Le module optoélectronique réalisé sous la forme d'un composant du type DIL est de plus relativement volumineux étant donné que les pattes de connexion ont un écartement bien défini, ce qui constitue un autre inconvénient. De plus, il ne peut être ajusté qu'en hauteur pour le fixer en fonction de l'écart entre la carte mère et le fond du boîtier de la souris sur lequel peut être fixé le bloc transparent à lentille optique. Ceci nécessite aussi un ajustement de la carte mère par rapport à l'endroit où doit être fixé ou placé le bloc transparent à lentille optique du module optoélectronique, ce qui est désavantageux. Dans un mode de réalisation, le module optoélectronique est connecté à la carte mère par un cable plat flexible.

Pour pouvoir ajuster plus facilement en hauteur un module optoélectronique lors de son montage dans un instrument électronique, on peut citer la demande de brevet EP 1 081 944, qui décrit un module de caméra comprenant un dispositif d'imagerie comparable à un circuit photorécepteur. Le circuit photorécepteur est monté sur un substrat flexible et connecté par une technique dénommée flip chip sur des pistes métalliques d'une face inférieure d'un substrat flexible. Une ouverture est pratiquée au-dessus de la région photosensible du circuit photorécepteur et un bloc à lentille est monté sur la face supérieure dudit substrat par l'intermédiaire d'une plaque métallique. Le substrat flexible, qui est de même largeur que la plaque métallique, peut comprendre à une extrémité des bornes de contact pour une connexion éventuelle à une carte mère. Les bornes de contact sont reliées par l'intermédiaire de pistes métalliques à des plages de contact du circuit photorécepteur.

Les demandes de brevet US 2004/0095501 et WO 2005/088435 décrivent également un module optoélectronique de manière sensiblement équivalente à la demande de brevet EP 1 081 944. Cependant pour la demande de brevet US 2004/0095501, le circuit photorécepteur est monté et connecté électriquement directement sur une plaque de céramique (LTCC ou HTCC) ayant une ouverture au-dessus de la région photosensible du circuit photorécepteur et un bloc à lentille fixé sur une face opposée de la plaque céramique. Dans la demande de brevet WO 2005/088435, le circuit photorécepteur est monté et électriquement connecté à une plaque à circuit imprimé rigide. Un substrat flexible de connexion est monté par la suite sous le module optoélectronique pour relier électriquement le circuit photorécepteur et éventuellement d'autres circuits, dont un circuit source de lumière, à des bornes de contact à une autre extrémité dudit substrat pour être relié à une carte mère.

L'invention a donc pour but principal de fournir un module optoélectronique, qui permet de pallier les inconvénients de l'art antérieur cités ci-devant, relativement peu volumineux et ajustable en hauteur et/ou dans la plan du substrat pour faciliter son montage dans un boîtier d'un instrument électronique, tel qu'une souris d'ordinateur.

A cet effet, l'invention concerne un module optoélectronique, qui comprend les caractéristiques mentionnées dans la revendication 1.

Des formes d'exécution spécifiques du module optoélectronique sont définies dans les revendications dépendantes 2 à 10.

Un avantage du module optoélectronique selon l'invention est qu'il comprend un substrat flexible avec une première portion portant au moins le circuit photorécepteur, une seconde portion à bornes de connexion électrique, et une portion de liaison des première et seconde portions. Grâce à cette portion de liaison, il est possible d'ajuster en hauteur la première portion par rapport à la seconde portion, et également d'ajuster l'écartement entre les première et seconde portions du substrat flexible. Grâce à ce substrat flexible, il est possible de positionner le circuit photorécepteur de la première portion du substrat sur un bloc transparent à lentille optique indépendamment de la position de l'endroit de connexion des bornes de connexion du module de la seconde portion du substrat.

Dans le cas d'un montage du module optoélectronique dans une souris d'ordinateur, le bloc transparent à lentille optique est fixé sur une ouverture du fond du boîtier de la souris d'ordinateur. La première portion du substrat flexible avec le circuit photorécepteur, enfermé en partie sous un couvercle, est montée directement sur le bloc transparent. La seconde portion du substrat flexible avec les bornes de connexion peut être librement ajustée en hauteur pour sa connexion à une carte mère à circuit imprimé par rapport à la première portion du substrat. L'écartement entre la première portion et la seconde portion peut également être ajusté grâce à la portion de liaison. Cet écartement peut être compris entre un écart maximum correspondant à la longueur de la portion de liaison et un écart minimum de proximité de la première portion par rapport à la seconde portion du substrat flexible. De ce fait, le module optoélectronique peut être facilement monté dans tout type de souris d'ordinateur indépendamment de la position précise de la carte mère par rapport à l'ouverture du fond du boîtier de la souris.

Avantageusement, un couvercle opaque est disposé sur la première portion du substrat flexible du côté du circuit photorécepteur. Un passage de lumière à travers le couvercle est prévu au-dessus d'une région photosensible du circuit photorécepteur, alors qu'une région à unité de traitement du circuit est protégée de la lumière. Ce passage de lumière peut être dans une partie en saillie extérieure du couvercle.

Avantageusement, le couvercle comprend deux ergots de positionnement dans un logement intérieur dans lequel est placé le circuit photorécepteur, et éventuellement encore un circuit source de lumière. Ces ergots sont disposés à proximité de deux angles diamétralement opposés à l'intérieur d'un logement. Chaque ergot s'étend du fond du logement vers l'extérieur du logement. Chaque ergot est de forme générale cylindrique et de diamètre différent l'un de l'autre pour servir de détrompeur lors du montage sur la première portion du substrat flexible. Pour ce faire, la première portion du substrat flexible comprend deux trous de diamètre différent correspondant au diamètre de chaque ergot, et positionnés de manière à être traversés par les ergots lors du montage du couvercle sur la première portion.

A cet effet, l'invention concerne également une souris d'ordinateur, qui comprend un module optoélectronique, selon les caractéristiques définies dans la revendication 11.

Les buts, avantages et caractéristiques du module optoélectronique apparaîtront mieux dans la description suivante de formes d'exécution non limitatives illustrées par les dessins sur lesquels :
la figure 1 représente une vue de dessus d'une première forme d'exécution d'un module optoélectronique selon l'invention,
la figure 2 représente une vue tridimensionnelle en éclaté d'une seconde forme d'exécution du module optoélectronique selon l'invention,
la figure 3 représente une vue de côté en coupe longitudinale partielle d'une troisième forme d'exécution du module optoélectronique avec un bloc transparent à lentille optique selon l'invention, et
la figure 4 représente de manière simplifiée une vue tridimensionnelle en coupe partielle d'une partie d'une souris d'ordinateur, qui comprend le module optoélectronique selon l'invention, sur une surface de travail.

Dans la description suivante, toutes les parties du module optoélectronique qui sont bien connues d'un homme du métier dans ce domaine technique ne sont relatées que de manière simplifiée. De préférence, ce module optoélectronique est réalisé pour une utilisation dans une souris d'ordinateur, mais il peut être envisagé d'utiliser ce module optoélectronique dans tout autre instrument ou appareil électrique.

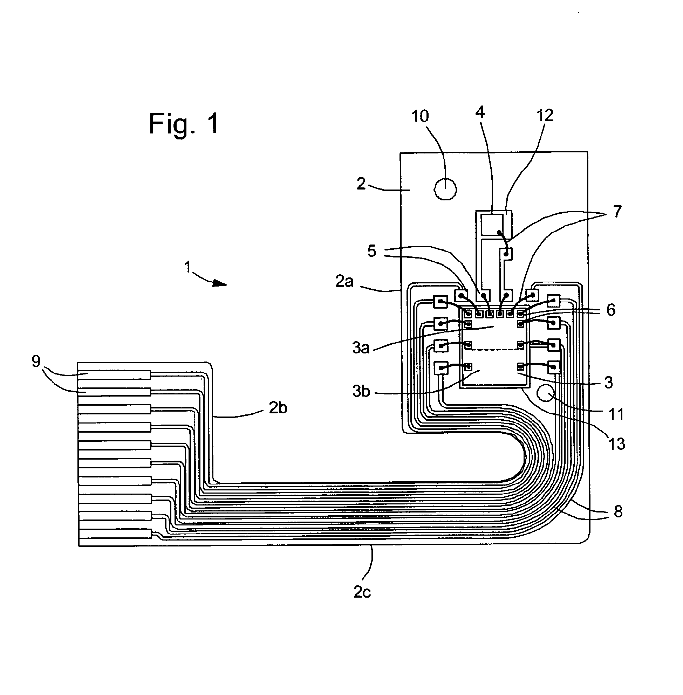

La figure 1 montre une vue de dessus du module optoélectronique 1 par exemple pour équiper une souris d'ordinateur. Ce module optoélectronique 1 comprend sur une première face d'un même substrat flexible 2, un circuit intégré photorécepteur 3 pour capter de la lumière générée par un circuit intégré source de lumière 4 notamment par réflexion sur une surface extérieure de travail. Le circuit photorécepteur 3 et le circuit source de lumière 4 sont montés sur une première portion 2a du substrat flexible 2. Des plages de contact 6 du circuit photorécepteur 3 sont électriquement connectées par des fils métalliques 7, tels que des fils en aluminium, à des plages de connexion correspondantes 5 disposées sur une première face du substrat. Ces plages de connexion 5 sont reliées à des pistes conductrices, de préférence métalliques 8 du substrat pour former un circuit imprimé. Ces pistes conductrices 8 peuvent être disposées sur une face ou l'autre du substrat flexible.

Le substrat flexible 2 est sous la forme d'une feuille flexible dont l'épaisseur peut être par exemple de l'ordre de 75 µm. Ce substrat flexible 2 comprend en plus de la première portion 2a encore une seconde portion 2b comprenant des bornes de connexion électrique 9 et une portion de liaison 2c entre la première portion et la seconde portion. Ces bornes de connexion métalliques 9 sont reliées directement à certaines pistes conductrices 8 de la première portion par l'intermédiaire de la portion de liaison 2c. Ces bornes de connexion 9, pour servir de connecteur électrique, peuvent être disposées sur la première face du substrat, ainsi que sur une seconde face opposée. Une liaison métallique, par exemple par trous métallisés, peut être envisagée à travers la seconde portion 2b du substrat flexible 2 pour électriquement relier les parties des bornes de connexion 9 disposées sur les deux faces du substrat.

Le circuit intégré source de lumière 4 utilisé peut être une diode laser ou une diode électroluminescente. Normalement, une première face du circuit source de lumière 4 est directement connectée sur une plage de connexion spécifique 12 de la première portion du substrat. Par contre, une plage de contact d'une seconde face opposée du circuit source de lumière est connectée par un fil métallique 7, tel qu'un fil en or, sur une autre plage correspondante 5 de la première portion 2a du substrat flexible 2. Une face opposée aux plages de contact 6 du circuit photorécepteur 3 peut être également électriquement reliée à une grande plage spécifique de connexion 13 sur la première portion 2a du substrat flexible 2. Cette plage spécifique de connexion 13 est reliée à une piste conductrice pour être reliée à une borne d'alimentation électrique du circuit photorécepteur, notamment la masse, par l'intermédiaire des bornes de connexion 9.

Il est à noter que le circuit source de lumière 4 est uniquement relié électriquement par l'intermédiaire de deux pistes métalliques 8 de la première portion 2a à des plages de contact 6 du circuit photorécepteur 3. Aucune borne de connexion 9 de la seconde portion du type connecteur n'est électriquement reliée au circuit source de lumière 4. Ainsi, ce circuit source de lumière peut être protégé de toute décharge électrostatique ESD par des diodes de protection réalisées dans le circuit photorécepteur 3.

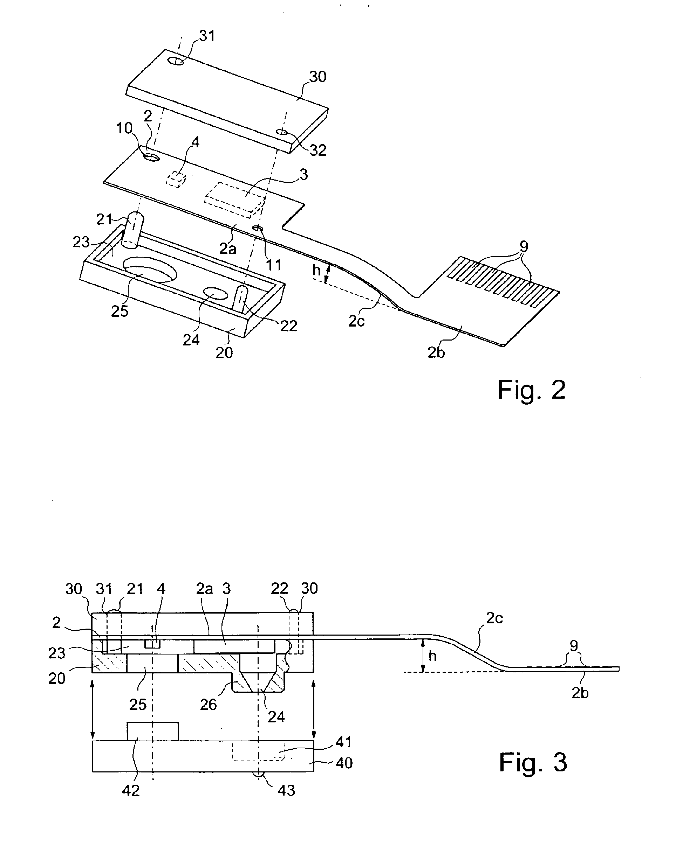

Le circuit photorécepteur 3 comprend une région photosensible 3b juxtaposée à une région à unité de traitement 3a des signaux fournis par plusieurs éléments photosensibles de la région photosensible 3b, non représentés. Normalement la région à unité de traitement 3a du circuit photorécepteur doit être à l'abri de la lumière. Il peut donc être encapsulé dans une résine opaque traditionnelle avec les différentes plages de contact du circuit et de la première portion, tout en laissant découverte la région photosensible 3b pour capter de la lumière. Dans la seconde forme d'exécution décrite ci-après en référence à la figure 2, cette région à unité de traitement est protégée de la lumière à l'aide d'un couvercle opaque, de préférence de couleur foncée, telle que noire.

Comme ce substrat flexible comporte des première et seconde portions 2a, 2b reliées par l'intermédiaire d'une portion de liaison 2c, il est possible d'opérer un ajustement en hauteur et/ou de l'écartement de la seconde portion par rapport à la première portion. La hauteur représente la distance séparant les deux plans constitués par les première et seconde portions 2a et 2b. Ceci procure un avantage considérable lors du montage du module optoélectronique 1 notamment dans une souris d'ordinateur comme expliqué ci-après.

Pour le montage de la première portion 2a du substrat flexible 2 sur un support ou un couvercle pour enfermer en partie le circuit photorécepteur 3, il est prévu deux trous de positionnement 10, 11 à travers la première portion. Comme la forme de cette première portion vue de dessus est sensiblement rectangulaire, chaque trou est positionné à proximité de deux angles diamétralement opposés de la première portion 2a. Ces trous de positionnement sont circulaires et de diamètre différent pour servir de détrompeur lors du montage de la première portion sur deux ergots respectifs d'un support, de diamètre différent correspondant à celui de chaque trou.

La portion de liaison 2c du substrat flexible 2 peut être est réalisée sous forme de L entre les première et seconde portions 2a et 2b, vu dans un même plan, avec une courbure à l'angle du L. La largeur de cette portion de liaison est inférieure à la largeur d'un côté de la première portion 2a depuis lequel la portion de liaison est reliée. De préférence, cette largeur est inférieure à la moitié de la largeur de la première portion. La longueur totale de cette portion de liaison 2c peut être comprise entre la moitié et deux fois la longueur de la première portion 2a.

La portion de liaison 2c est reliée à un côté de la première portion 2a en léger décalage par rapport au centre de ce côté. Ceci permet d'avoir moins de courbure et donc moins de tension mécanique sur le substrat flexible lors de la fixation du module optoélectronique 1 d'une part à une carte mère et d'autre part sur le fond du boîtier d'une souris d'ordinateur. De plus, la longueur de cette portion de liaison doit être choisie pour minimiser tout effet parasite liés aux pistes métalliques qu'elle porte.

Bien entendu, il peut aussi être envisagé de monter le circuit photorécepteur 3 sur la première portion 2a du substrat flexible 2 par une technique dénommée "flip chip" en terminologie anglaise non illustrée. Pour ce faire, des bosses métalliques sont réalisées sur les plages métalliques de contact 6 du circuit photorécepteur 3 dépassant de la couche de passivation. Ces bosses métalliques sont connectées directement sur des plages correspondantes du substrat disposées selon un même arrangement et positionnement que les bosses métalliques. Par cette technique de montage, il doit encore être prévu une ouverture dans la première portion 2a du substrat flexible 2 en regard de la région photosensible 3b pour la réception de la lumière par cette région. Par contre le circuit source de lumière 4 doit en principe être monté sur une face opposée à la face portant le circuit photorécepteur 3. Une connexion électrique à travers la première portion doit donc être prévue pour relier le circuit source de lumière 4 au circuit photorécepteur 3.

Il est à noter qu'avec un montage du circuit photorécepteur 3 par cette technique dénommée "flip chip", il est possible de réaliser la première portion 2a du substrat flexible moins large que le montage représenté en figure 1. De cette manière, un gain de place peut être obtenu dans le boîtier de la souris d'ordinateur par un tel module optoélectronique 1.

La figure 2 représente une vue tridimensionnelle en éclaté d'une seconde forme d'exécution du module optoélectronique 1. Dans cette seconde forme d'exécution, la partie de liaison 2c du substrat flexible 2 est réalisée par exemple sous forme rectiligne entre la première portion 2a et la seconde portion 2b. Cependant, il est représenté sur cette figure 2 un ajustement en hauteur h entre la première portion 2a et la seconde portion 2b par l'intermédiaire de la portion de liaison 2c présentant des parties courbées. La seconde portion 2b porte des bornes de connexion électrique 9, qui sont réalisées sur les deux faces de la seconde portion 2b.

Le module optoélectronique 1 comprend donc le circuit photorécepteur 3 et le circuit source de lumière 4 placés sur une même face de la première portion 2a du substrat flexible 2. Ce module comprend encore un couvercle 20 opaque à la lumière, par exemple en plastique de couleur noire, qui sert à rigidifier la première portion 2a du substrat 2 et qui est isolant électriquement. De plus, le module peut comprendre une plaque de fond 30 sur la première portion 2a, d'un même matériau ou d'un autre matériau que le couvercle, qui est rigide, opaque à la lumière et électriquement isolant. Le couvercle 20 est donc disposé sur la première portion 2a du substrat flexible 2 du côté du circuit photorécepteur 3 et du circuit source de lumière 4. Ce couvercle comprend un passage de lumière 24, sous la forme d'un diaphragme. Ce passage de lumière 24 est disposé au-dessus de la région photosensible du circuit photorécepteur 3. Ce passage de lumière est réalisé dans le couvercle depuis une partie en saillie extérieure du couvercle, non représentée en figure 2.

Le couvercle comprend également une ouverture 25 pour le passage de la lumière générée par la source de lumière 4. Cette ouverture 25 de forme circulaire est prévue également pour recevoir une portion de lentille optique d'un bloc transparent à lentille optique, et est de plus grande dimension que la surface d'émission du circuit source de lumière.

Le couvercle 20 comprend encore deux ergots parallèles de positionnement 21 et 22, qui sont disposés à proximité de deux angles diamétralement opposés à l'intérieur d'un logement 23. Le circuit photorécepteur 3 et le circuit source de lumière 4 sont protégés à l'intérieur de ce logement 23. Chaque ergot, qui s'étend du fond du logement verticalement vers l'extérieur du logement, est de forme générale cylindrique et de diamètre différent l'un de l'autre. La longueur de chaque ergot est ainsi plus grande que la profondeur du logement pour dépasser en dehors du logement.

La première portion 2a du substrat flexible comprend un premier trou 10 de diamètre correspondant au diamètre d'un des ergots 21, et un second trou 11 de diamètre correspondant au diamètre de l'autre ergot 22. Ces deux trous 10, 11 sont traversés par les ergots dans une orientation et un positionnement bien définis par la forme des ergots lors du montage du couvercle 20 sur la première portion 2a. La longueur et la largeur du couvercle correspondent à la longueur et la largeur de la première portion 2a du substrat flexible 2.

Le module optoélectronique peut comprendre encore une plaque 30 opaque à la lumière, d'un même matériau ou d'un autre matériau que le couvercle, qui est disposée sur une face de la première portion 2a opposée à celle du couvercle. La première portion 2a est ainsi prise en sandwich entre le couvercle 20 et ladite plaque 30 pour rigidifier cette partie du module. Cette plaque comprend également deux trous traversants 31, 32 ayant un même emplacement et de même diamètre que les trous 10, 11 de la première portion 2a du substrat flexible 2. Les trous de la plaque sont également traversés par les ergots 21, 22, dont l'extrémité libre peut être arrondie ou chanfreinée pour faciliter leur introduction dans chaque trou. Une fois que la plaque est montée avec la première portion sur le couvercle, les extrémités des ergots peuvent être fixées à la plaque par un chauffage adéquat ou un collage.

La figure 3 représente une vue de côté en coupe longitudinale partielle d'une troisième forme d'exécution du module optoélectronique 1. La seule différence de cette troisième forme d'exécution du module optoélectronique 1 par rapport au module présenté à la figure 2, est qu'il comprend encore un bloc transparent à lentille optique 40 montré avant sa fixation sur le couvercle 20.

Il est à noter que sur cette figure 3, tous les éléments du module optoélectronique 1 portent des signes de référence identiques aux mêmes éléments décrits en référence aux figures 1 et 2. De ce fait par simplification, il ne sera pas répété la description de chaque élément pour cette troisième forme d'exécution.

Le couvercle 20 représenté partiellement en coupe, comprend une partie en saillie extérieure 26 de forme générale cylindrique. Un passage de lumière 24 est ainsi réalisé sous forme d'un diaphragme pour la réception de la lumière par la région photosensible du circuit photorécepteur. La lumière est générée par le circuit source de lumière 4 et réfléchie sur une surface de travail pour être reçue à travers le passage de lumière par la région photosensible du circuit photorécepteur 3.

Le bloc transparent à lentille optique 40 est monté sur une surface extérieure du couvercle 20. La surface de ce bloc transparent, qui vient en contact sur le couvercle 20, peut être de forme complémentaire à la surface extérieure du couvercle. Ainsi, une partie sous forme de lentille 42 du bloc transparent peut venir se loger dans l'ouverture 25 du couvercle au-dessus du circuit source de lumière 4. De plus, une partie complémentaire 41 du bloc transparent vient couvrir la partie en saillie 26 du couvercle 20. Une lentille 43 peut être formée dans le bloc transparent juste au-dessus du passage de lumière 24.

Ce bloc transparent bouche ainsi l'ouverture 25 et le passage 24 afin également de protéger les deux circuits 3, 4 dans le logement 23 de la poussière et des conditions de l'environnement. Ce bloc transparent 40 peut être réalisé en verre ou de préférence en plastique. Le bloc transparent peut être fixé sur le couvercle avec de la colle ou grâce à des moyens d'accrochage non représentés.

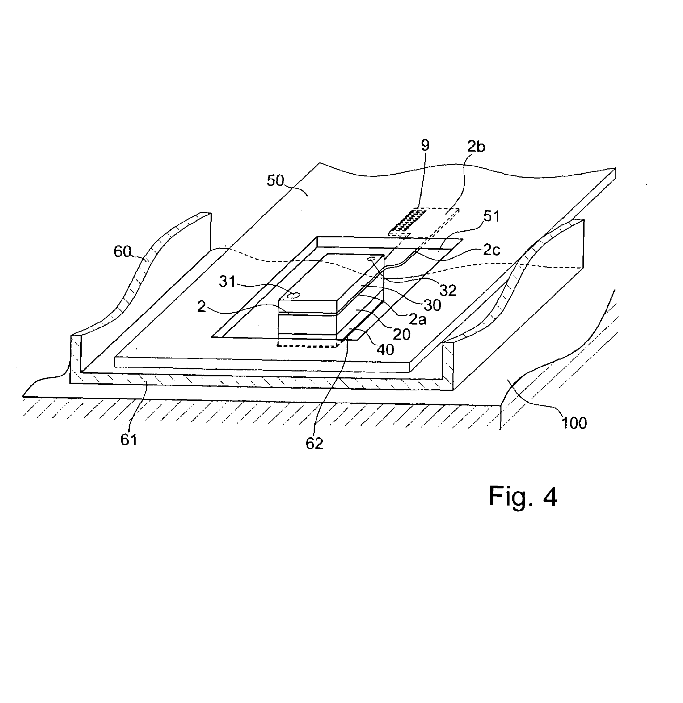

Le module optoélectronique complet 1 peut donc équiper une souris d'ordinateur 60 comme montré de manière simplifiée et partiellement en coupe à la figure 4. Le boîtier de la souris optique 60 comprend un fond 61 posé sur une surface de travail 100. Comme ci-dessus, la plupart des éléments du module qui portent les mêmes signes de référence que sur les figures précédentes ne seront pas expliqués par simplification.

Le module optoélectronique est monté à l'intérieur du boîtier de la souris 60 au-dessus du fond 61 dudit boîtier. Le bloc transparent à lentille optique 40, qui est fixé au couvercle 20, est placé sur une ouverture 62 du fond 61 du boîtier de la souris, qui peut être de surface égale à la surface supérieure du bloc transparent. Ce bloc transparent peut être accroché ou fixé sur le fond 61 du boîtier. De par cette fixation sur le fond du boîtier, la position de la première portion 2a du substrat flexible 2, qui est maintenue entre la plaque 30 et le couvercle 20, est bien déterminée.

L'ensemble, qui comprend le couvercle 20, la première portion 2a du substrat 2 et la plaque 30 est placé en partie à travers une ouverture traversante 51 d'une carte mère à circuit imprimé 50. Cette carte mère 50 est fixée dans le boîtier de la souris 60 à une distance définie du fond 61, qui peut être différent d'un type de souris à l'autre. Ainsi grâce à la portion de liaison 2c du substrat flexible 2, qui est libre de se courber, les bornes de connexion 9 de la seconde portion 2b peuvent être facilement connectées à des plages de connexion correspondantes de la carte mère voisines de l'ouverture traversante 51. De ce fait, un ajustement en hauteur et de l'écartement entre la première portion 2a et la seconde portion 2b peut être effectué par la portion de liaison 2c indépendamment du type de souris d'ordinateur dans lequel le module optoélectronique est monté.

A partir de la description qui vient d'être faite, de multiples variantes de réalisation du module optoélectronique peuvent être conçues par l'homme du métier sans sortir du cadre de l'invention définie par les revendications. La portion de liaison peut être une partie angulaire ou de charnière entre les première et seconde portions du substrat flexible. La seconde portion peut être fixée sur une carte mère de manière perpendiculaire à la première portion grâce à une torsion de la portion de liaison.

## Revendications

1. Module optoélectronique (1) destiné à être placé dans un boîtier (60) d'une souris d'ordinateur, qui comprend au moins un circuit photorécepteur (3) susceptible de capter de la lumière provenant d'une source de lumière directement ou par réflexion sur une surface extérieure, le circuit photorécepteur étant monté directement sur un substrat (2), des plages de contact (6) du circuit photorécepteur étant électriquement connectées (7) à des plages correspondantes (5) du substrat, qui sont reliées à des pistes conductrices (8) du substrat, le substrat étant un substrat flexible, qui comprend une première portion (2a) sur laquelle est monté et électriquement connecté le circuit photorécepteur (3), une seconde portion (2b) comprenant des bornes de connexion électrique (9) et une portion de liaison (2c) entre la première portion et la seconde portion pour relier certaines pistes conductrices (8) de la première portion aux bornes de connexion (9) de la seconde portion, la portion de liaison permettant un ajustement en hauteur et/ou de l'écartement de la seconde portion par rapport à la première portion, la portion de liaison (2c), qui est reliée à un côté de la première portion (2a), étant d'une largeur inférieure à la moitié de la largeur du côté de la première portion et en décalage par rapport au centre de ce côté, la portion de liaison (2c) du substrat flexible (2) étant réalisée sous forme de L entre les première et seconde portions avec une courbure à l'angle du L, et la longueur de la portion de liaison (2c) étant comprise entre la moitié et deux fois la longueur de la première portion (2a).

2. Module optoélectronique (1) selon la revendication 1, **caractérisé en ce que** les plages de contact (6) du circuit photorécepteur (3) sont reliées par des fils métalliques de connexion aux plages correspondantes (5) de la première portion (2a) du substrat flexible (2), et **en ce que** le circuit photorécepteur comprend une première région photosensible (3b) pour capter la lumière reçue et une seconde région (3a) juxtaposée à unité de traitement des signaux fournis par la première région.

3. Module optoélectronique (1) selon l'une des revendications précédentes, **caractérisé en ce qu'**un circuit source de lumière (4) est monté sur une même face de la première portion (2a) du substrat flexible (2) que le circuit photorécepteur (3), et **en ce que** le circuit source de lumière (4) est relié électriquement par l'intermédiaire d'au moins deux pistes conductrices (8) de la première portion uniquement à au moins deux plages de contact (6) du circuit photorécepteur (3), aucune borne de connexion (9) de la seconde portion (2b) n'étant reliée au circuit source de lumière.

4. Module optoélectronique (1) selon la revendication 1, **caractérisé en ce que** des bosses métalliques sont réalisées sur les plages de contact du circuit photorécepteur de manière à être directement connectées sur des plages correspondantes du substrat disposées selon un même arrangement que les bosses métalliques, **en ce que** le circuit photorécepteur comprend une première région photosensible (3b) pour capter la lumière reçue et une seconde région (3a) juxtaposée à unité de traitement des signaux fournis par la première région, et **en ce qu'**une ouverture de passage de lumière est prévue à travers la première portion du substrat flexible en regard de la première région photosensible (3b).

5. Module optoélectronique (1) selon la revendication 4, **caractérisé en ce qu'**un circuit source de lumière (4) est monté sur la première portion (2a) du substrat flexible (2) sur une face opposée à la face du circuit photorécepteur (3), et **en ce que** le circuit source de lumière (4) est relié électriquement par l'intermédiaire d'au moins deux pistes conductrices (8) traversant la première portion uniquement à au moins deux plages de contact (6) du circuit photorécepteur (3), aucune borne de connexion (9) de la seconde portion (2b) n'étant reliée au circuit source de lumière.

6. Module optoélectronique (1) selon l'une des revendications 1 à 3, **caractérisé en ce qu'**il comprend un couvercle opaque disposé sur la première portion du substrat flexible du côté du circuit photorécepteur (3), **en ce que** le couvercle comprend un passage de lumière (24) disposé au-dessus d'une région photosensible (3b) du circuit photorécepteur (3) et réalisé dans une partie en saillie (26) extérieure du couvercle.

7. Module optoélectronique (1) selon la revendication 6, **caractérisé en ce que** le couvercle (20) comprend deux ergots de positionnement (21, 22) disposés à proximité de deux angles diamétralement opposés à l'intérieur d'un logement (23) pour le circuit photorécepteur (3), **en ce que** chaque ergot, qui s'étend du fond du logement vers l'extérieur du logement, est de forme générale cylindrique et de diamètre différent l'un de l'autre, et **en ce que** la première portion (2a) du substrat flexible (2) comprend un premier trou (10) de diamètre correspondant au diamètre d'un des ergots, et un second trou de diamètre correspondant au diamètre de l'autre ergot pour être traversés dans une orientation et un positionnement bien définis par les ergots.

8. Module optoélectronique (1) selon la revendication 7, **caractérisé en ce qu'**un circuit source de lumière (4) est monté dans le logement (23) du couvercle (20) sur une même face de la première portion (2a) du substrat flexible (2) que le circuit photorécepteur, et en que le couvercle comprend une ouverture (25) pour le passage de la lumière générée par la source de lumière, cette ouverture étant prévue pour recevoir une portion de lentille optique (42) d'un bloc transparent (40), et de plus grande dimension que la surface d'émission du circuit source de lumière.

9. Module optoélectronique (1) selon l'une des revendications 7 et 8, **caractérisé en ce qu'**il comprend une plaque opaque (30) muni de deux trous traversants (31, 32) de diamètre équivalent aux trous (10, 11) du substrat flexible (2) et positionnés de manière équivalente aux trous du substrat flexible, pour être traversés par les deux ergots du couvercle afin d'enfermer la première portion (2a) du substrat entre le couvercle (20) et la plaque.

10. Module optoélectronique (1) selon l'une des revendications 6 à 9, **caractérisé en ce qu'**un bloc transparent (40) est monté sur une partie de la surface extérieure du couvercle (20) et formé avec une partie complémentaire à la surface extérieure du couvercle, et **en ce que** le bloc transparent comprend au moins une lentille disposée sur le passage de lumière (24) au-dessus de la partie en saillie (26) sur la région photosensible (3b) du circuit photorécepteur (3).

11. Souris d'ordinateur comprenant un module optoélectronique selon la revendication 10, la souris d'ordinateur comprenant dans un boîtier (60), une carte mère à circuit imprimé (50) espacé d'un fond (61) du boîtier, **caractérisé en ce que** le bloc transparent à lentille (40) du module est fixé sur le fond du boîtier au-dessus d'une ouverture traversante (62) réalisée dans le fond du boîtier pour le passage et la réception de la lumière, **en ce que** l'ensemble constitué du couvercle (20) et de la première portion (2a) du substrat flexible (2) est fixé à l'intérieur du boîtier sur le bloc transparent et disposé en partie à l'intérieur d'une ouverture traversante (51) de la carte mère, et **en ce que** les bornes de connexion (9) de la seconde portion (2b) du substrat flexible (2) sont connectées à des plages de connexion correspondantes de la carte mère voisines de l'ouverture traversante de ladite carte, la hauteur et/ou l'écartement de la seconde portion étant ajusté par l'intermédiaire de la portion de liaison (2c), et par rapport à la première portion (2a) du substrat flexible (2), ainsi qu'en fonction de l'espace entre la carte mère et le fond du boîtier.

## Claims

1. Optoelectronic module (1), intended to be mounted in a case (60) of a computer mousse, which includes at least one photoreceptor circuit (3) able to pick up light originating from a light source directly or via reflection on an external surface, the photoreceptor circuit being directly mounted on a substrate (2), contact pads (6) of the photoreceptor circuit being electrically connected (7) to corresponding pads (5) of the substrate, which are connected to conductive paths (8) of the substrate, the substrate being a flexible substrate, which includes a first portion (2a) on which the photoreceptor circuit (3) is mounted and electrically connected, a second portion (2b) including electrical connection terminals (9) and a connecting portion (2c) between the first portion and the second portion for connecting some conductive paths (8) of the first portion to the connection terminals (9) of the second portion, the connecting portion allowing the height and/or spacing of the second portion to be adjusted relative to the first portion, the connecting portion (2c), which is connected to one side of the first portion (2a), being of a width less than half the width of the side of the first portion and shifted relative to the centre of this side, the connecting portion (2c) of the flexible substrate (2) being made in an L shape between the first and second portions with a curve at the corner of the L, and the length of the connecting portion (2c) being comprised between half and twice the length of the first portion (2a).

2. Optoelectronic module (1) according to claim 1, **characterized in that** the contact pads (6) of the photoreceptor circuit (3) are connected by metal connecting wires to the corresponding pads (5) of the first portion (2a) of the flexible substrate (2), and **in that** the photoreceptor circuit includes a first photosensitive area (3b) for picking up the light received and a second area (3a) juxtaposed with a unit for processing signals supplied by the first area.

3. Optoelectronic module (1) according to any of the preceding claims, **characterized in that** a light source circuit (4) is mounted on the same face of the first portion (2a) of the flexible substrate (2) as the photoreceptor circuit (3), and **in that** the light source circuit (4) is electrically connected via at least two conductive paths (8) of the first portion solely to at least two contact pads (6) of the photoreceptor circuit (3), no connection terminal (9) of the second portion (2b) being connected to the light source circuit.

4. Optoelectronic module (1) according to claim 1, **characterized in that** metal bumps are made on the contact pads of the photoreceptor circuit in order to be directly connected to the corresponding pads of the substrate arranged in the same arrangement as the metal bumps, **in that** the photoreceptor circuit includes a first photosensitive area (3b) for picking up the light received and a second area (3a) juxtaposed with the unit for professing signals provided by the first area, and **in that** a light passage aperture is provided through the first portion of the flexible substrate opposite the first photosensitive area (3b).

5. Optoelectronic module (1) according to claim 4, **characterized in that** a light source circuit (4) is mounted on the first portion (2a) of the flexible substrate (2) on a face opposite the face of the photoreceptor circuit (3), and **in that** the light source circuit (4) is electrically connected via at least two conductive paths (8) passing through the first portion solely to at least two contact pads (6) of the photoreceptor circuit (3), no connection terminal (9) of the second portion (2b) being connected to the light source circuit.

6. Optoelectronic module (1) according to any of claims 1 to 3, **characterized in that** it includes an opaque cover arranged on the first portion of the flexible substrate on the side of the photoreceptor circuit (3), **in that** the cover includes a light passage (24) arranged above a photosensitive area (3b) of the photoreceptor circuit (3) and made in an external projecting part (26) of the cover.

7. Optoelectronic module (1) according to claim 6, **characterized in that** the cover (20) includes two positioning pins (2.1, 22) arranged in proximity to two diametrically opposite corners inside a housing (23) for the photoreceptor circuit (3), **in that** each pin, which extends from the bottom of the housing towards the exterior of the housing, is of generally cylindrical shape and has a different shape from the other pin, and **in that** the first portion (2a) of the flexible substrate (2) includes a first hole (10) whose diameter corresponds to the diameter of one of the pins, and a second hole, whose diameter corresponds to the diameter of the other pin in order for the pins to pass therethrough in a well defined orientation and position.

8. Optoelectronic module (1) according to claim 7, **characterized in that** a light source circuit (4) is mounted in the housing (23) of the cover (20) on the same face of the first portion (2a) of the flexible substrate (2) as the photoreceptor circuit, and **in that** the cover includes an aperture (25) for the passage of the light generated by the light source, said aperture being provided for receiving an optical lens portion (42) of a transparent unit (40), and of larger dimensions than the transmission surface of the light source circuit.

9. Optoelectronic module (1) according to any of claims 7 and 8, **characterized in that** it includes an opaque plate (30) fitted with two through holes (31, 32) of the same diameter as the holes (10, 11) in the flexible substrate (2) and positioned in the same manner as the holes of the flexible substrate, in order for the two pins of the cover to pass therethrough to enclose the first portion (2a) of the substrate (2) between the cover (20) and the plate.

10. Optoelectronic module (1) according to any of claims 6 to 9, **characterized in that** a transparent unit (40) of complementary shape to the external surface of the cover is mounted on one part of the external surface of the cover (20), and **in that** the transparent unit includes at least one lens arranged on the light passage (24) above the projecting part (26) on the photosensitive area (3b) of the photoreceptor circuit (3).

11. Compute mouse including an optoeloctronic module according to claim 10, the computer mouse including in a case (60), a mother printed circuit board (50) at a distance from bottom (61) of the case, **characterized in that** the transparent lens unit (40) of the module is secured to the bottom of the case above a through aperture (62) made in the bottom of the case for the passage and deception of light, **in that** the assembly formed of the cover (20) and the first portion (2a) of the flexible substrate (2) is secured inside the case on the transparent unit and arranged in part inside a through aperture (51) in the mother board, and **in that** the connecting terminals (9) of the second portion (2b) of the flexible substrate (2) are connected to corresponding connecting pads of the mother board next to the through aperture in said board, the height and/or the spacing of the second portion being adjusted via the connecting portion (2c), and with respect to the first portion (2a) of the flexible substrate (2), and as a function of the space between the mother board and the bottom of the case.

## Patentansprüche

1. Optoelektronisches Modul (1) zur Platzierung in einem Gehäuse (60) einer Computermaus vorgesehen, welches zumindest eine Fotorezeptorschaltung (3) aufweist, die zum Erfassen von Licht ausgebildet ist, weiches von einer Lichtquelle direkt oder durch Reflexion an einer externen Fläche bereitgestellt wird, wobei die Fokorezepkorschaltung direkt auf ein Substrat (2) montiert ist, Kontaktbereiche (6) der Fotorezeptorschaltung mit korrespondierenden Bereichen (5) des Substrats elektrisch kontaktiert (7) sind, welche mit Leiterbahnen (8) des Substrats verbunden sind, wobei das Substrat ein flexibles Substrat ist, welches einen ersten Abschnitt (2a) aufweist, auf weichem die Fotorezeptorschaltung montiert und elektrisch verbunden ist, einen zweiten, elektrische Kontaktklemmen (9) aufweisenden zweiten Abschnitt (2b) und einen Verbindungsabschnitt (2c) zwischen dem ersten Abschnitt und dem zweiten Abschnitt aufweist, um bestimmte Leiterbahnen (8) des ersten Abschnitts mit Kontaktklemmen (9) des zweiten Abschnittes zu verbinden, wobei der Verbindungsabschnitt einen Höhen- und/oder eine Spaltjustierung des zweiten Abschnitts ges genüber dem ersten Abschnitt ermöglicht, der Verbindungsabschnitt (2), welder mit einer Seite des ersten Abschnitts (2a) verbunden ist, eine geringere Breite als die Hälfte der Breite der Seite des ersten Abschnitts aufweist und in Verschiebung gegenüber der Mitte dieser Seite des Verbindungsabschnitts (2c) des flexiblen Substrats (2) unter Bildung eines L zwischen dem ersten und dem zweiten Abschnitt eine Krümmung eines L-artigen Winkels aufweist, und wobei die Länge des Verbindungsabschnitts (2c) zwischen der Hälfte und dem Zweifachen der Länge des ersten Abschnitts (2a) liegt.

2. Optoelektronisches Modul (1) nach Anspruch 1, **dadurch gekennzeichnet, dass** die Kontaktbereiche (6) der Fotorezeptorschaltung (3) über metallische Verbindungsdrähte mit korrespondierenden Bereichen (5) des ersten Abschnitts (2a) des flexiblen Substrats (2) verbunden sind, und wobei die Fotorezeptorschaltung einen ersten lichtempfindlichen Abschnitt (3b) zum Erfassen empfangenen Lichts und einen danebenliegenden vereinten zweiten Abschnitt (3a) zum Verarbeiten der von dem ersten Abschnitt erzeugten Signale aufweist.

3. Optoelektronisches Modul (1) nach einem der vorhergehender Ansprüche, **dadurch gekennzeichnet, dass** eine Laserlichtquelle (4) auf derselben Seite des ersten Abschnitts (2a) des flexiblen Substrats (2) wie die Fotorezeptorschaltung (3) angeordnet ist, und wobei die Laserlichtquelle (4) über zumindest zwei Leiterbahnen (8) des ersten Abschnitts einzig und allein mit zumindest zwei Kontaktklemmen (6) der Fotorezeptorschaitung (3) elektrisch verbunden ist, wobei keine einzige Kontaktklemme (9) des zweiten Abschnitts (2b) mit der Laserlichtquelle verbunden ist.

4. Oµtoelektronisches Modul (1) nach Anspruch 1, **dadurch gekennzeichnet, dass** metallische Erhöhungen auf den Kontaktbereichen der Fotorezoptorschalfung derart vorgesehen sind, um direkt mit korrespondierenden Bereichen des Substrats verbunden zu werden, welches eine entsprechende Anordnung wie die metallischen Erhöhungen aufweist, wobei die Fotorezeptorschaltung einen ersten lichtsensitiven Abschnitt (3b) aufweist, um Licht zu erfassen, und einen danebenliegenden vereinten zweiten Abschnitt (3a) zum Verarbeiten der von dem ersten Abschnitt erzeugten Signale aufweist und wobei eine Lichtdurchgangsöffnung durch den ersten Abschnitt des flexiblen Substrats im Hinblick auf den ersten lichtsensitiven Abschnitt (3b) vorgesehen ist.

5. Optoelektronisches Modul (1) nach Anspruch 4, **dadurch gekennzeichnet, dass** eine Laserlichtquelle (4) auf dem ersten Abschnitt (2a) des flexiblen Substrats (2) auf einer Seite gegenüber der Seite der Fotorezeptorschaltung (3) angeordnet ist und wobei die Laserlichtquelle (4) über zumindest zwei Leiterbahnen (8), welche den ersten Abschnitt einzig und allein über zumindest zwei Kontaktklemmen (6) der Fotorezeptorschaltung (3) durchqueren, elektrisch verbunden ist, wobei keine einzige Kontaktklemme (9) des zweiten Abschnittes (2b) mit der Laserlichtquelle verbunden ist.

6. Optoelektronisches Modul (1) nach einem der Ansprüche 1 bis 3, **dadurch gekennzeichnet, dass** es einen opaken Verschlussdeckel aufweist, welcher am ersten Abschnitt des flexiblen Substrats auf der Seite des Fotorezeptors (3) angeordnet ist, wobei der Verschlussdeckel eine Lichtdurchgangspassage (24) aufweist, die oberhalb eines lichtempfindlichen Bereichs (3b) der Fotorezeptorschaltung (3) angeordnet und in einem außerhalb des Verschlussdeckels Vorsprungsabschnitt (26) verwirklicht ist.

7. Optoelektronische Modul (1) nach Anspruch 6, **dadurch gekennzeichnet, dass** der Verschlussdeckel (20) zwei Positionsnocken (21, 22) aufweist, welche in der Nähe zweier diametraler gegenüberliegender Ecken im Inneren einer Behausung (23) der Fotorezeptorschaltung (3) angeordnet sind, wobei die Nocken, welche sich vom Boden der Behausung zur Außenseite des Gehäuses erstrecken, eine zylindrische Form und unterschiedliche Durchmesser aufweisen, wobei der erste Abschnitt (2a) des flexiblen Substrats (2) ein erstes Loch (10) eines mit dem Durchmesser einer Nocke korrespondierenden Lochs und ein zweites Loch mit einem Durchmesser aufweist, welcher mit dem Durchmesser der anderen Nocke korrespondiert, um in einer von den Nocken definierten Ausrichtung und Positionierung durchsetzt zu werden.

8. Optoelektronisches Modul (1) nach Anspruch 7, **dadurch gekennzeichnet, dass** eine Laserlichtquelle (4) in der Behausung (23) des Verschlussdeckels (20) auf derselben Seite des ersten Abschnitts (2a) des flexiblen Substrats wie die Fotorezeptorschaltung angeordnet ist, und wobei der Verschlussdeckel eine Öffnung (25) für die Passage von Licht aufweist, welches von der Laserlichtquelle erzeugbar ist, wobei die Öffnung dazu vorgesehen ist, einen Abschnitt einer optischen Linse (42) einer transparenten Einheit (40) aufzunehmen, welche größere Abmessungen als die Emissionsoberfläche der Laserlichtquelle aufweist.

9. Optoelektronisches Modul (1) nach einem der Ansprüche 7 und 8, **dadurch gekennzeichnet, dass** es eine opake Plakette (30) aufweist, die mit zwei Durchgangslöchern (31, 32) versehen ist, welche einen Durchmesser aufweisen, der mit den Löchern (10, 11) des flexiblen Substrats (2) äquivalent ist und weiche in einer äquivalenten Art und Weise an den Löchern des flexiblen Substrats positioniert sind, um von den Nocken des Vorschlussdeckels durchsetzt zu werden, um den ersten Abschnitt (2a) des Substrats zwischen dem Verschlussdeckel (20) und der Plakette zu verschließen.

10. Optoelektronisches Modul (1) nach einem der Ansprüche 6 und 9, **dadurch gekennzeichnet, dass** eine transparente Einheit (40) auf einer Seite der Außenoberfläche des Verschlusseieckels (20) mit einem mit der Außenoberfläche des Verschlussdeckels komplementären Abschnitt geformt ist, und wobei die transparente Einheit zumindest eine Linse aufweist, die auf der Lichtpassage (24) oberhalb des Vorsprungsabschnitts (26) auf dem lichtempfindlichen Abschnitt (3b) der Fotorezeptorschaltung (3) angeordnet ist.

11. Computermaus, welche ein optoelektronisches Modul nach Anspruch 10 aufweist, wobei die Computermaus in einem Gehäuse (60) eine Grundplatine mit einer gedruckten, vom Boden (61) des Gehäuses beabstandeten Schaltung (50) aufweist, **dadurch gekennzeichnet, dass** die transparente Linseneinheit (40) des Moduls auf dem Boden des Gehäuses oberhalb einer Durchgangsöffnung (62) fixiert ist, welche im Boden des Gehäuses zum Durch, gang und zur Aufnahme von Licht vorgesehen ist und wobei die aus dem Verschlussdeckel (20) und dem ersten Abschnitt (2a) des flexiblen Substrats (2) gebildete Anordnung im Inneren des Gehäuses auf der transparenten Einheit fixiert und bereichsweise im Inneren einer Durchgangsöffnung (51) der Grundplatine angeordnet ist, wobei die Verbindungsklemmen (9) des ersten Abschnitts (2b) des flexiblen Substrats (2) mit korrespondierenden Kontaktklemmen der Grundplatine neben der Durchgangsöffnung der Platine angeordnet sind, die Höhe und/oder der Spaltabstand des zweiten Abschnittes über den Verbindungsabschnitt (2c) gegenüber dem ersten Abschnitt (2a) des flexiblen Substrats (2) regelbar und daher entsprechend dem Abstand zwischen der Grundplatine und dem Boden des Gehäuses ist.
